# FASCICULE DE BREVET EUROPEEN

(11) **EP 1 742 870 B1**
(45) Date de publication et mention de la délivrance du brevet: **14.11.2007**
(21) Numéro de dépôt: 05746642.7
(22) Date de dépôt: 19.04.2005
(51) Int. Cl.: C01B 33/037

(54) **PROCEDE ET INSTALLATION DE FABRICATION DE BLOCS D'UN MATERIAU SEMICONDUCTEUR**
VERFAHREN UND VORRICHTUNG ZUR HERSTELLUNG VON BLÖCKEN AUS HALBLEITERMATERIAL
METHOD AND INSTALLATION FOR THE PRODUCTION OF BLOCKS OF A SEMICONDUCTOR MATERIAL

(30) Priorité: 20.04.2004 FR 0450738
(43) Date de publication de la demande: 17.01.2007
(73) Titulaire: EFD Induction SA, 38170 Seyssinet Pariset (FR)
(72) Inventeur: RIVAT, Pascal, F-38590 SAINT ETIENNE DE SAINT GEOIRS (FR); DEL GOBBO, Jean-Pierre, La Grivolée, 38410 URIAGE (FR)
(74) Mandataire: de Beaumont, Michel
(86) Numéro de dépôt international: PCT/FR2005/050258
(87) Numéro de publication internationale: WO 2005/105670

(56) Documents cités:
- FR-A- 2 827 592
- FR-A- 2 831 881
- YUGE N ET AL: "Purification of metallurgical-grade silicon up to solar grade" PROGRESS IN PHOTOVOLTAICS. RESEARCH AND APPLICATIONS, JOHN WILEY AND SONS, CHICHESTER, GB, vol. 9, no. 3, mai 2001 (2001-05), pages 203-209, XP002203294 ISSN: 1062-7995

## Description

La présente invention concerne la fabrication d'un matériau semiconducteur, notamment du silicium, pour constituer des cellules de production d'énergie électrique par effet photovoltaïque.

Actuellement, le silicium destiné aux techniques photovoltaïques est essentiellement constitué des rebuts de l'industrie microélectronique, car le silicium utilisé pour des applications photovoltaïques peut contenir une proportion d'impuretés (de l'ordre de 10⁻⁶) moins critique que le niveau d'impuretés (10⁻⁹) généralement requis en microélectronique.

Il serait souhaitable de disposer d'une autre source de silicium pour produire du silicium adapté aux produits photovoltaïques. En particulier, les rebuts de l'industrie microélectrique risquent de devenir rapidement insuffisants pour satisfaire les besoins des techniques photovoltaïques.

Actuellement, on cherche à affiner le silicium fabriqué pour des applications métallurgiques pour obtenir du silicium d'une pureté adaptée aux techniques photovoltaïques. Le silicium utilisé en métallurgie peut contenir plusieurs pourcent d'impuretés telles que le fer, le titane, le bore, le phosphore, etc.

Un exemple de procédé d'affinage est décrit dans le brevet français FR 2 772 741 au nom du C.N.R.S. Toutefois, ce document ne décrit pas un procédé complet de fabrication industrielle de blocs de silicium directement utilisables pour la réalisation de produits photovoltaïques ni une installation de fabrication industrielle de blocs de silicium directement utilisables pour la réalisation de produits photovoltaïques.

La présente invention vise à proposer un procédé et une installation de fabrication de blocs d'un matériau semiconducteur, notamment du silicium, présentant un degré de pureté suffisant pour une utilisation directe pour la réalisation de produits photovoltaïques et/ou de fabrication de blocs du matériau semiconducteur ayant un degré de pureté inférieur au niveau requis pour une utilisation directe pour la réalisation de produits photovoltaïques et destinés à être traités ultérieurement pour présenter un degré de pureté suffisant pour les techniques photovoltaïques, ledit procédé et ladite installation permettant une fabrication industrielle complètement automatisable de tels blocs du matériau semiconducteur.

La présente invention vise en outre un procédé et une installation de fabrication de blocs du matériau semiconducteur permettant la fabrication industrielle continue des blocs du matériau semiconducteur.

Pour atteindre ces objets, la présente invention prévoit une installation de fabrication de blocs d'un matériau semiconducteur, comprenant au moins une première enceinte contenant une atmosphère d'au moins un gaz neutre et comprenant un système de fusion adapté à faire fondre le matériau semiconducteur, un système de purification adapté à éliminer des impuretés du matériau semiconducteur fondu, et un système de déplacement d'un creuset de cristallisation contenant du matériau semiconducteur fondu et purifié par le système de purification ; et comprenant au moins une seconde enceinte contenant une atmosphère dudit au moins un gaz neutre et reliée à la première enceinte par une ouverture, une porte mobile étant adaptée à fermer hermétiquement ladite ouverture, le système de déplacement étant adapté à déplacer le creuset de cristallisation dans la seconde enceinte avant que le matériau semiconducteur fondu et purifié ne commence à se solidifier, la seconde enceinte contenant un système de refroidissement adapté à favoriser la solidification du matériau semiconducteur fondu et purifié.

Selon un mode de réalisation de l'invention, le système de refroidissement est adapté à favoriser la ségrégation d'impuretés lors de la solidification du matériau semiconducteur fondu et purifié dans la seconde enceinte.

Selon un mode de réalisation de l'invention, le système de refroidissement est adapté à favoriser la solidification du matériau semiconducteur fondu et purifié sans ségrégation d'impuretés dans la seconde enceinte.

Selon un mode de réalisation de l'invention, la première enceinte est divisée en une enceinte principale et une enceinte secondaire communiquant avec l'enceinte principale par une ouverture, une porte mobile étant adaptée à fermer hermétiquement ladite ouverture, l'enceinte secondaire contenant le système de fusion et le système de purification, l'enceinte principale contenant au moins en partie le système de déplacement et la seconde enceinte étant reliée à l'enceinte principale.

Selon un mode de réalisation de l'invention, le système de fusion comprend un creuset de fusion, distinct du creuset de cristallisation, l'installation comprenant un moyen pour verser du matériau semiconducteur fondu et purifié du creuset de fusion dans le creuset de cristallisation.

Selon un mode de réalisation de l'invention, le creuset de fusion est un creuset froid basculant.

Selon un mode de réalisation de l'invention, le système de fusion est adapté à faire fondre du matériau semiconducteur directement dans le creuset de cristallisation.

Selon un mode de réalisation de l'invention, le système de déplacement comprend un bras articulé dont l'extrémité libre est adaptée à se fixer temporairement au creuset de cristallisation.

Selon un mode de réalisation de l'invention, l'installation comprend un écran de protection s'interposant entre le système de fusion et le système de purification et adapté à délimiter avec une paroi de la première enceinte un volume de confinement contenant le système de purification, l'écran de protection comportant un orifice en vis-à-vis duquel est destinée à être placée la surface libre du matériau semiconducteur fondu par le système de fusion lors du fonctionnement du système de purification.

La présente invention prévoit également un procédé de fabrication de blocs d'un matériau semiconducteur comprenant les étapes consistant à remplir un creuset de fusion du matériau semiconducteur solide dans une première enceinte contenant une atmosphère d'au moins un gaz neutre ; à faire fondre le matériau semiconducteur solide ; à éliminer des impuretés du matériau semiconducteur fondu ; à déplacer automatiquement le creuset de fusion, ou un creuset de cristallisation dans lequel du matériau semiconducteur fondu et purifié a été versé, depuis la première enceinte dans une seconde enceinte, contenant une atmosphère dudit au moins un gaz neutre et reliée à la première enceinte, avant le début de la solidification du matériau semiconducteur fondu et purifié ; à isoler hermétiquement la seconde enceinte de la première enceinte ; et à refroidir le matériau semiconducteur dans la seconde enceinte pour solidifier le matériau semiconducteur fondu et purifié.

Ces objets, caractéristiques et avantages, ainsi que d'autres de la présente invention seront exposés en détail dans la description suivante des exemples de réalisation particuliers faite à titre non-limitatif en relation avec les figures jointes parmi lesquelles :
la figure 1 est une coupe partielle et schématique de dessus d'un premier exemple de-réalisation d'une installation de fabrication de silicium selon l'invention ;
la figure 2 est une coupe partielle et schématique selon la ligne II-II de la figure 1 ;
les figures 3A à 3D illustrent des étapes successives d'un exemple de procédé de fabrication selon l'invention ;
la figure 4 est une coupe schématique d'une partie de l'installation de fabrication selon l'invention ; et
la figure 5 est une coupe partielle et schématique de, côté d'un second exemple de réalisation d'une installation de fabrication selon l'invention.

De mêmes éléments ont été désignés par de mêmes références aux différentes figures. Pour des raisons de clarté, seuls les éléments de l'installation qui sont nécessaires à la compréhension de l'invention ont été représentés aux différentes figures.

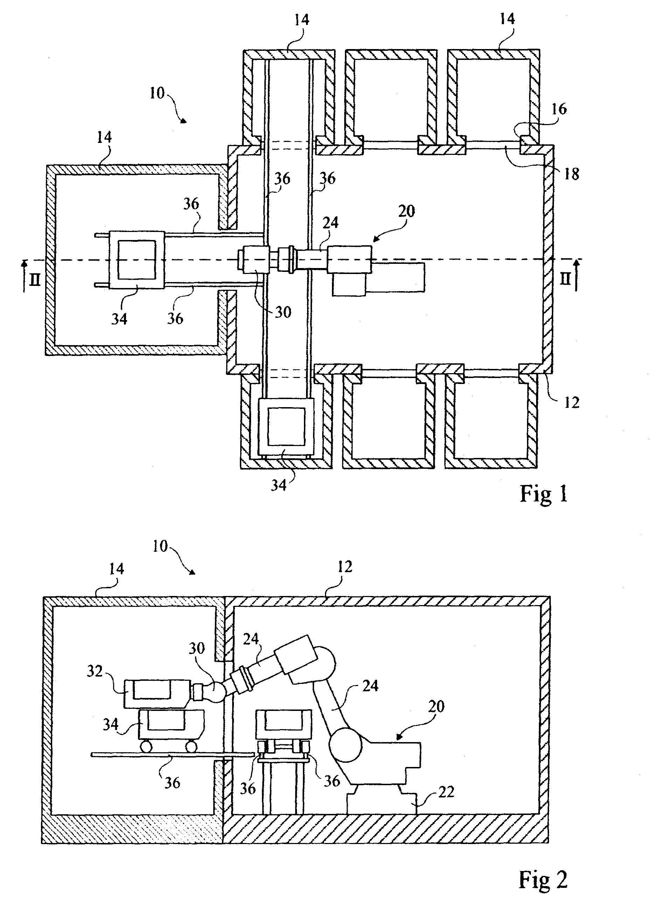

Les figures 1 et 2 représentent un premier exemple de réalisation d'une installation 10 de fabrication de silicium comprenant une enceinte principale 12 parallélépipédique à côtés rectangulaires et des enceintes secondaires 14 parallélépipédiques à côtés rectangulaires réparties autour de l'enceinte principale 12. A titre d'exemple, cinq enceintes secondaires 14 sont représentées en figure 1. Des ouvertures 16 sont prévues au travers de l'enceinte principale 12 et de chaque enceinte secondaire 14 et permettent de faire communiquer le volume interne de l'enceinte principale 12 avec le volume interne de chaque enceinte secondaire 14. L'installation 10 comprend une porte étanche 18 au niveau de chaque ouverture 16 pour isoler hermétiquement le volume interne de l'enceinte principale 12 du volume interne de l'enceinte secondaire 14 associée. Chaque porte 18, par exemple du type battante ou coulissante, est actionnée par un mécanisme non représenté permettant de libérer l'ouverture 16 entre l'enceinte secondaire 14 correspondante et l'enceinte principale 12.

Une atmosphère d'un gaz neutre, ou d'un mélange de gaz neutres, par exemple de l'argon ou de l'hélium, à -une pression légèrement supérieure à la pression atmosphérique est maintenue dans l'enceinte principale 12 et dans les enceintes secondaires 14 pour éviter la pénétration d'oxygène dans les différentes enceintes. Lorsque la porte 18 associée à une enceinte secondaire 14 est fermée, une atmosphère de gaz neutre peut être maintenue dans l'enceinte secondaire 14 à une pression différente de la pression dans l'enceinte principale 12. Au moins une enceinte secondaire 14 comporte une ouverture, non représentée, pouvant être fermée hermétiquement et débouchant sur l'extérieur de l'installation 10. Une telle enceinte secondaire joue le rôle d'un sas d'entrée/sortie pour l'introduction ou le retrait d'objets dans l'installation 10. L'enceinte secondaire d'entrée/sortie 14 comprend alors un moyen pour établir une atmosphère du gaz neutre dans ladite enceinte secondaire d'entrée/sortie 14 avant l'ouverture de la porte 18 la reliant à l'enceinte principale 12. Par ailleurs, l'installation 10 selon l'invention peut comprendre un accès direct à l'enceinte principale 12 pour en faciliter l'entretien.

L'enceinte principale 12 comprend un robot porteur 20, constitué par exemple d'un bras polyarticulé, représenté schématiquement en figures 1 et 2, comportant une base 22 fixée à l'enceinte principale 12 à partir de laquelle s'étendent plusieurs tronçons 24 articulés les uns par rapport aux autres. L'extrémité libre du robot porteur 20 comprend un moyen d'accroche 30 adapté à se fixer à un creuset 32. Il s'agit, par exemple, d'un creuset à base de silice. Le robot porteur 20 est commandé automatiquement, par exemple par un programme de commande prémémorisé. Le robot porteur 20 peut être commandé pour faire pénétrer le moyen d'accroche 30 dans une première enceinte secondaire 14 par l'ouverture 16 correspondante, fixer le moyen d'accroche 30 à un creuset 32 disposé dans la première enceinte secondaire 14, et déplacer le creuset 32 ainsi fixé au moyen d'accroche 30 pour le retirer de l'enceinte secondaire 14 par l'ouverture 16 associée et l'amener dans une seconde enceinte secondaire 14.

Selon une variante de l'invention, l'installation 10 comprend un creuset 34 monté mobile sur des rails 36. Le robot porteur 20 est alors adapté à tirer ou pousser le creuset roulant 34 sur les rails 36. Les rails 36 pénètrent dans certaines enceintes secondaires 14 par l'intermédiaire des ouvertures 16 correspondantes. Le robot porteur 20 est alors adapté à déplacer le creuset roulant 34 depuis une première enceinte secondaire vers une seconde enceinte secondaires.

Parmi les enceintes secondaires 14, une enceinte secondaire contient un système de fusion et de purification et une enceinte secondaire contient un système de refroidissement (non représentés aux figures 1 et 2). A titre d'exemple, en figure 1, l'enceinte secondaire 14 accolée au flanc gauche de l'enceinte principale 12, de volume plus important, comprend le système de fusion et de purification. Les autres enceintes secondaires 14 contiennent chacune un système de refroidissement comme cela sera décrit plus en détail par la suite.

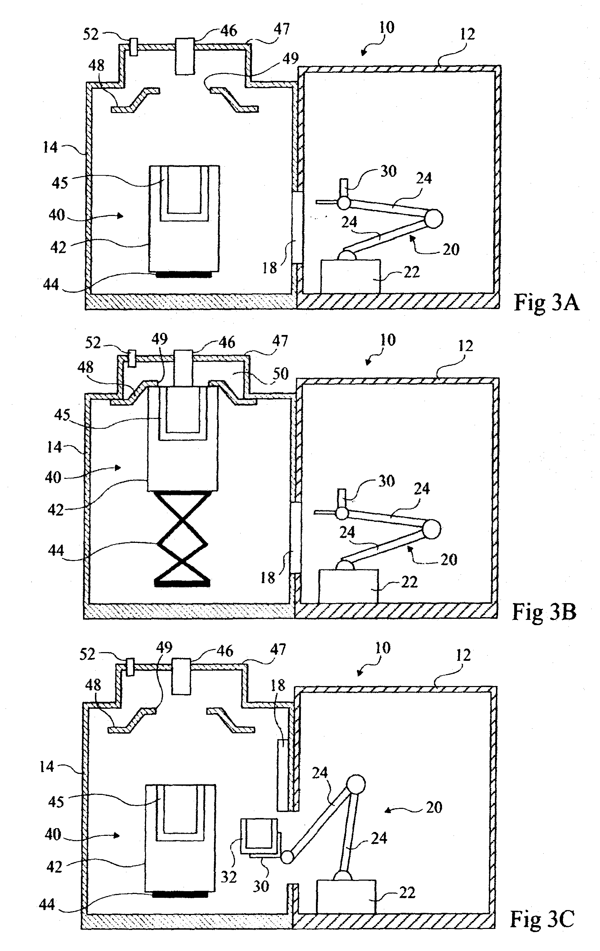

Les figures 3A à 3D représentent schématiquement l'enceinte principale 12 et l'enceinte secondaire 14 contenant le système de fusion et de purification 40, appelée par la suite enceinte de fusion et de purification. Le système de fusion et de purification 40 comprend un four à induction 42 monté sur un système d'élévation et de basculement 44 permettant un déplacement vertical du four 42 et un basculement du four 42 autour d'un axe horizontal. Le four à induction 42 comprend une bobine d'induction, non représentée, entourant un creuset de fusion 45 cylindrique du type creuset chaud ou creuset froid, constitué, par exemple, d'un creuset à base de graphite mélangé à de l'argile ou à base de carbure de silicium pourvu d'un contre-creuset intérieur à base de silice. Le four 42 comprend un bec de coulée non représenté. Le système de fusion et de purification 40 comprend une torche à plasma inductif 46 disposée au niveau d'une paroi supérieure 47 de l'enceinte secondaire 14 à l'aplomb du four à induction 42. La torche à plasma inductif 46 est associée à un injecteur de gaz réactifs (non représenté) tels que de l'oxygène, du chlore, de l'azote, etc.

L'enceinte secondaire 14 de fusion et de purification comprend un système d'alimentation, non représenté, du creuset de fusion 45 en morceaux de silicium métallurgique, par exemple sous la forme de granules. Il peut s'agir d'une trémie escamotable. L'enceinte 14 comprend en outre un écran de protection 48, de forme annulaire, contenant une ouverture centrale 49, adapté à être déplacé selon la direction verticale entre une position basse de repos et une position haute à laquelle l'écran de protection 48 est à proximité de la paroi supérieure 47 de l'enceinte secondaire 14 et délimite avec la paroi supérieure 47 un volume de confinement 50. L'écran de protection 48 est déplacé par le four à induction 42 et guidé en déplacement par un système de guidage non représenté. Lorsque le four 42 et l'écran de protection 48 sont en position haute, le contenu du creuset de fusion 45 est exposé à la torche à plasma 46 par l'ouverture 49 de l'écran de protection 48. L'enceinte secondaire 14 comprend un système 52 d'évacuation des composés volatils présents dans le volume de confinement 50. Il s'agit, par exemple, d'une buse reliée à une pompe d'aspiration, favorisant la formation d'un mouvement tourbillonnaire dans le volume de confinement 50 afin d'évacuer les composés volatils et les composés solides qui pourraient se former dans les zones froides du volume de confinement 50.

Les premières étapes du procédé de fabrication du silicium selon l'invention vont maintenant être décrites en relation aux figures 3A à 3D.

La figure 3A illustre une première étape dans laquelle l'enceinte secondaire 14 de fusion et de purification est isolée de l'enceinte principale 12 par la fermeture de la porte 18 associée. Le four à induction 42 est alors en position basse. Le système d'alimentation est commandé pour verser des granules de silicium métallurgiques dans le creuset de fusion 45. Les granules de silicium sont alors fondus en alimentant la bobine du four 42 par une tension à fréquence moyenne, par exemple de l'ordre d'une dizaine de kilohertz pour un creuset de fusion 45 cylindrique de quelques centaines de millimètres de diamètre. Le remplissage du creuset de fusion 45 est progressif, de nouveaux granules de silicium étant ajoutés lorsque les granules de silicium précédemment versés dans le creuset de fusion 45 ont fondu, jusqu'à ce que le creuset de fusion 45 soit pratiquement rempli à ras bord. La fréquence de la tension d'alimentation de la bobine du four à induction 42 est alors diminuée pour favoriser un brassage du silicium fondu dans le creuset de fusion 45.

La figure 3B illustre l'étape de purification du silicium fondu dans le creuset de fusion 45. Pour ce faire, le four à induction 42 est surélevé par le système d'élévation et de basculement 44 jusqu'à ce que la surface libre du silicium fondu dans le creuset de fusion 45 soit dans une position adaptée pour être balayée efficacement par la torche à plasma 46. Lors du mouvement ascendant, le four à induction 42 entraîne l'écran de protection 48 et le rapproche de la paroi supérieure 47. En position haute, l'écran de protection 48 délimite avec la paroi supérieure 47 et le four 42, le volume de confinement 50.

La purification du silicium fondu est alors réalisée dans laquelle différents gaz réactifs sont introduits dans le plasma. Les gaz réactifs réagissent avec des impuretés présentes dans le silicium liquide de façon à former des composés volatils qui sont évacués par l'intermédiaire du système d'évacuation 52. Toutefois, les gaz réactifs tendent également à réagir avec le silicium fondu pour former des composés volatils tels que SiO qui doivent également être évacués. L'écran de protection 48 protège le four à induction 42 lors du fonctionnement de la torche à plasma 46 et tend à retenir les composés volatils dans le volume de confinement 50. L'écran de protection 48 peut être refroidi lors du fonctionnement de la torche à plasma 46. Pour éviter tout passage indésirable de composés volatils depuis le volume de confinement 50 vers le reste de l'enceinte 14, il est avantageux de prévoir une surpression dans l'enceinte 14 par rapport au volume de confinement 50. On peut prévoir, en outre, au niveau de l'écran de protection 48, un rideau gazeux limitant encore davantage le passage de composés volatils depuis le volume de confinement 50 vers le reste de l'enceinte secondaire 14. Au cours de la purification, le four à induction 42 peut être déplacé pour ajuster la position de la surface libre du silicium fondu contenu dans le creuset de fusion 45 pour que la surface libre se trouve en permanence dans une position adaptée pour être balayée efficacement par la torche à plasma 46. En outre, du silicium solide peut être ajouté dans le creuset de fusion 45 au cours de la purification pour ajuster le niveau du silicium fondu.

Avant la fin de la purification, le robot porteur 20 est commandé pour amener un creuset de cristallisation 32 dans une autre enceinte secondaire 14 dans laquelle le creuset 32 est préchauffé par un système de chauffage. Juste avant la fin de la purification, le robot porteur 20 est commandé pour chercher le creuset 32 préchauffé et l'amener dans l'enceinte principale 12.

La figure 3C illustre l'étape pendant laquelle le four à induction 42 est déplacé en position basse à la fin de l'étape de purification. La porte 18 de l'enceinte 14 de fusion et de purification est ouverte permettant au robot porteur 20 d'introduire le creuset 32 préchauffé dans l'enceinte 14 de fusion et de purification.

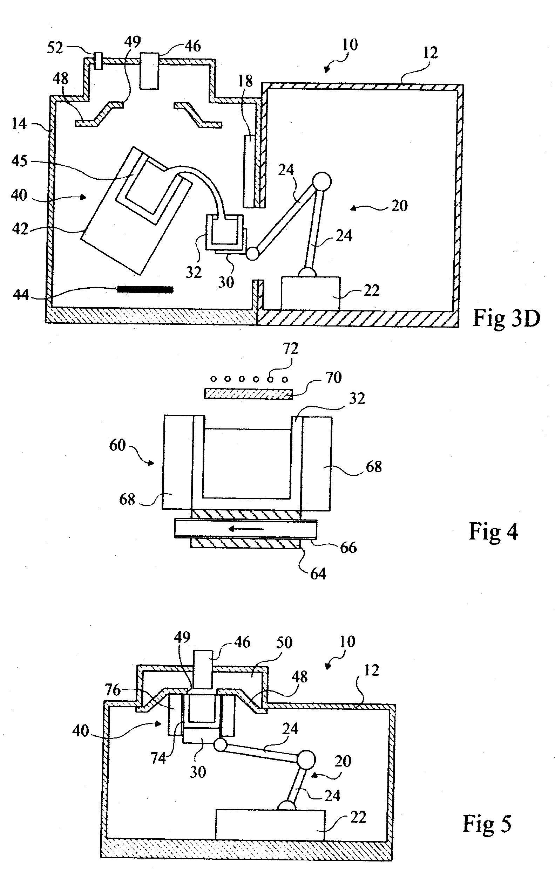

La figure 3D illustre l'étape pendant laquelle le four 42 est basculé, par l'intermédiaire du système d'élévation et de basculement 44, pour verser du silicium fondu et purifié depuis le creuset de fusion 45 vers le creuset de cristallisation 32. Une partie du silicium fondu et purifié peut être conservé dans le creuset de fusion 45 pour faciliter la fonte des granules de silicium lors d'un prochain remplissage du creuset de fusion 45.

Les étapes suivantes du procédé de fabrication selon l'invention consiste à commander le robot porteur 20 pour retirer le creuset de cristallisation 32 de l'enceinte secondaire 14 de fusion et de purification 40 et le déposer dans une autre enceinte secondaire 14 comprenant un système de refroidissement tel que représenté en figure 4. La durée du transfert du creuset de cristallisation 32 entre les deux enceintes 14 doit être suffisamment brève pour éviter tout début de solidification du silicium fondu et purifié. La durée du transfert est avantageusement inférieure à 1 minute, et de préférence inférieure à 30 secondes.

La figure 4 représente schématiquement un exemple de système de refroidissement 60 dans lequel est disposé un creuset de cristallisation 32 contenant du silicium fondu et purifié à partir duquel on souhaite obtenir un bloc de silicium ayant une qualité suffisante pour des techniques photovoltaïques. Le système de refroidissement comprend une semelle 64 sur laquelle est déposée le creuset de cristallisation 32. La semelle 64 est constituée d'un matériau bon conducteur de la chaleur et est refroidie par un fluide de refroidissement circulant dans des conduites 66 traversant la semelle 64. Le système de refroidissement comprend en outre des plaques latérales 68 entourant le creuset de cristallisation 32. Chaque plaque latérale 68 est constituée d'un matériau limitant au maximum tout échange thermique avec le creuset 32. Le système de refroidissement 60 comprend une plaque de diffusion 70, en vis-à-vis de la surface libre du silicium contenu dans le creuset 32, la plaque de diffusion 70 étant constituée d'un matériau bon conducteur de la chaleur qui est chauffée par l'intermédiaire d'une bobine d'induction 72. Un tel système de refroidissement 60 permet de solidifier progressivement le silicium contenu dans le creuset de cristallisation 32 depuis la base du creuset 32 jusqu'à la surface libre du silicium en contrôlant le front de solidification du silicium qui correspond dans ce cas sensiblement à un plan parallèle à la base du creuset 32 et qui progresse depuis la base du creuset 32 jusqu'à la surface libre. On favorise alors la ségrégation des impuretés dans la phase liquide du silicium au cours de la solidification qui sont piégées au niveau de la surface libre du bloc de silicium solide obtenu. Il suffit alors de retirer une couche superficielle en surface du bloc de silicium pour obtenir un bloc de silicium adapté à la réalisation de produits photovoltaïques. La forme du bloc de silicium solidifié dépend de la forme intérieure du creuset de cristallisation 32. On utilise alors de préférence un creuset de cristallisation 32 à base rectangulaire pour obtenir un bloc de silicium parallélépipédique. Un tel système de refroidissement 60 est avantageusement utilisé lorsqu'on souhaite obtenir un bloc de silicium dont le degré de pureté est suffisant pour une utilisation directe pour la fabrication de produits photovoltaïques et que le silicium de base utilisé pour le remplissage du creuset de fusion 45 a un degré de pureté tel qu'une solidification sans ségrégation d'impuretés du silicium fondu et purifié ne permettrait pas d'obtenir un bloc de silicium ayant un degré de pureté suffisant pour une utilisation directe pour la fabrication de produits photovoltaïques.

Une fois complètement solidifié, le creuset 32, contenant le bloc de silicium solidifié, est déplacé vers l'enceinte secondaire d'entrée/sortie pour être retiré de l'installation. Un nouveau creuset peut alors être introduit dans l'installation 10. L'enceinte secondaire 14 contenant le système de refroidissement 60 peut correspondre à l'enceinte d'entrée/sortie.

Le système de refroidissement 60 précédemment décrit peut être utilisé pour la préchauffe du creuset de cristallisation 32 comme cela a été décrit en relation à la figure 3B. En effet, un creuset 32 vide placé dans le système de refroidissement 60 peut être chauffé par l'intermédiaire de la plaque de diffusion 70.

Selon une variante de l'invention, le système de refroidissement comporte des moyens pour accélérer l'évacuation de calorie du creuset sans nécessairement favoriser une progression particulière du front de solidification du silicium contenu dans le creuset. On n'obtient pas alors de ségrégation des impuretés dans le bloc de silicium. Un tel système de refroidissement peut être utilisé pour l'obtention d'un bloc de silicium dont le degré de pureté est suffisant pour une utilisation directe pour la fabrication de produits photovoltaïques en utilisant du silicium pour le remplissage du creuset de fusion 45 ayant un degré de pureté suffisant de sorte que la solidification sans ségrégation d'impuretés du silicium fondu et purifié permette d'obtenir directement un bloc de silicium ayant un degré de pureté suffisant pour la fabrication de produits photovoltaïques. Dans le cas où le silicium utilisé pour le remplissage du creuset de fusion 45 a un degré de pureté tel qu'une solidification sans ségrégation d'impuretés du silicium fondu et purifié ne permet pas d'obtenir un bloc de silicium ayant un degré de pureté suffisant pour une utilisation directe pour la fabrication de produits photovoltaïques, le bloc de silicium obtenu est impropre à une utilisation directe pour des techniques photovoltaïques. Toutefois, un tel bloc peut être ultérieurement refondu pour fournir un bloc de silicium adapté à la réalisation de produits photovoltaïques.

Dans le cas de l'utilisation d'un système de refroidissement sans ségrégation d'impuretés, il n'est pas nécessaire de prévoir un creuset de cristallisation 32 favorisant la formation d'un front de solidification particulier lors de la solidification du silicium fondu et purifié. Le creuset 32 peut alors être une lingotière en cuivre ou en fonte. Un tel creuset étant généralement trop lourd pour être soulevé par le robot porteur 20, il est alors avantageux d'utiliser un creuset roulant 34 se déplaçant sur des rails 36, comme cela est illustré aux figures 1 et 2. Le robot porteur 20 déplace alors le creuset roulant 34 dans l'enceinte secondaire 14 contenant le système de fusion et de purification 40 pour le remplissage du creuset roulant 34 puis déplace le creuset roulant 34 vers une enceinte secondaire 14 contenant le système de refroidissement.

De façon générale, on peut alors prévoir, parmi les enceintes secondaires 14 entourant l'enceinte-principale 12, des enceintes secondaires comportant le système de refroidissement 60 représenté en figure 4 pour l'obtention de blocs de silicium directement utilisables pour la réalisation de produits photovoltaïques et des enceintes secondaires 14 contenant un système de refroidissement n'entraînant pas de ségrégation d'impuretés et permettant, selon la qualité du silicium utilisé pour remplir le creuset de fusion 45, l'obtention de blocs de silicium directement utilisables pour la réalisation de produits photovoltaïques ou l'obtention de blocs de silicium de qualité impropre pour une utilisation directe pour la réalisation de produits photovoltaïques mais pouvant être traités ultérieurement. Le nombre d'enceintes secondaires 14 contenant les systèmes de refroidissement est prévu pour permettre un fonctionnement continu de l'installation 10 selon l'invention. En effet, la durée de l'étape de solidification du silicium fondu et purifié est généralement supérieure à la durée des étapes de fusion et de purification.

La figure 5 représente un second exemple de réalisation de l'installation 10 de fabrication selon l'invention dans laquelle l'enceinte principale 12 et l'enceinte secondaire 14 contenant le système de fusion et de purification 40 sont confondues. Une ou plusieurs enceintes secondaires 14, non représentées, contenant chacune un système de refroidissement, peuvent être prévues autour de l'enceinte 12 de façon analogue à ce qui a été décrit en relation à la figure 1. Le robot porteur 20 est adapté à déplacer un creuset 74 qui joue à la fois le rôle du creuset de fusion 45 et du creuset de cristallisation 32 du premier exemple de réalisation. L'écran de protection 48 peut alors être maintenu en permanence à proximité de la paroi supérieure 47 de l'enceinte 12 pour délimiter le volume de confinement 50. Le système de fusion et de purification 40 comprend alors un système de chauffage par induction 76, constitué par exemple d'une ou de plusieurs bobines d'induction, disposé en permanence au niveau de l'écran de protection 48 à l'extérieur du volume de- confinement 50.

Le robot porteur 20 est adapté à déplacer le creuset 74 vers une première position dans laquelle le creuset 74 est rempli de granules de silicium solides, puis à déplacer le creuset 74 vers une seconde position, représentée en figure 5, dans laquelle le creuset 74 est entouré par le système de chauffage par induction 76. Le système de chauffage par induction est alors alimenté à une fréquence permettant la fusion du silicium dans le creuset 74. Une fois la fusion achevée, le système de chauffage par induction 76 est alimenté à une fréquence inférieure adaptée à favoriser le brassage du silicium fondu dans le creuset 74. La purification est alors réalisée comme cela a été décrit précédemment par l'intermédiaire de la torche à plasma 46. Une fois la purification achevée, le robot porteur 20 déplace le creuset 74 et le dépose dans une enceinte secondaire 14, non représentée, contenant un système de refroidissement entraînant la formation d'un bloc de silicium comme cela a été décrit précédemment.

Le second exemple de réalisation de l'installation de fabrication selon l'invention est avantageux par rapport au premier exemple de réalisation en ce qu'il évite l'étape de versement du silicium fondu et purifié depuis le creuset de fusion vers le creuset de cristallisation.

La présente invention a été décrite dans le cadre de la fabrication de silicium destiné aux techniques photovoltaïques. Il est clair qu'elle s'applique également à tout type de matériau semiconducteur pouvant être utilisé pour la réalisation de cellules photovoltaïques. De tels matériaux semiconducteurs sont, par exemple, l'arsenic de gallium (AsGa) ou le germanium (Ge).

Bien entendu, la présente invention est susceptible de diverses variantes et modifications qui apparaîtront à l'homme de l'art. En particulier, la purification du silicium fondu peut être réalisée par tout moyen adapté. En particulier, un système d'injection de bulles de gaz réactifs directement dans le silicium fondu peut être utilisé. De plus, l'enceinte principale et les enceintes secondaires peuvent avoir une forme différente de la forme parallélépipédique. A titre d'exemple, les enceintes peuvent avoir une forme générale cylindrique ou sphérique.

## Revendications

1. Installation (10) de fabrication de blocs d'un matériau semiconducteur, comprenant :
au moins une première enceinte (12, 14) contenant une atmosphère d'au moins un gaz neutre et comprenant un système de fusion (42) adapté à faire fondre le matériau semiconducteur, un système de purification (46) adapté à éliminer des impuretés du matériau semiconducteur fondu, et un système de déplacement (20) d'un creuset de cristallisation (32, 34) contenant du matériau semiconducteur fondu et purifié par le système de purification ; et
au moins une seconde enceinte (14) contenant une atmosphère dudit au moins un gaz neutre et reliée à la première enceinte par une ouverture (16), une porte mobile (18) étant adaptée à fermer hermétiquement ladite ouverture, le système de déplacement étant adapté à déplacer le creuset de cristallisation dans la seconde enceinte avant que le matériau semiconducteur fondu et purifié ne commence à se solidifier, la seconde enceinte contenant un système de refroidissement (60) adapté à favoriser la solidification du matériau semiconducteur fondu et purifié.

2. Installation selon la revendication 1, dans laquelle le système de refroidissement (60) est adapté à favoriser la ségrégation d'impuretés lors de la solidification du matériau semiconducteur fondu et purifié dans la seconde enceinte (14).

3. Installation selon la revendication 1, dans laquelle le système de refroidissement (60) est adapté à favoriser la solidification du matériau semiconducteur fondu et purifié sans ségrégation d'impuretés dans la seconde enceinte (14).

4. Installation selon la revendication 1, dans laquelle la première enceinte est divisée en une enceinte principale (12) et une enceinte secondaire (14) communiquant avec l'enceinte principale par une ouverture (16), une porte mobile (18) étant adaptée à fermer hermétiquement ladite ouverture, l'enceinte secondaire contenant le système de fusion (40) et le système de purification (46), l'enceinte principale contenant au moins en partie le système de déplacement (20) et la seconde enceinte (14) étant reliée à l'enceinte principale.

5. Installation selon la revendication 4, dans laquelle le système de fusion (42) comprend un creuset de fusion (45), distinct du creuset dé cristallisation (32, 34), l'installation comprenant un moyen pour verser du matériau semiconducteur fondu et purifié du creuset de fusion dans le creuset de cristallisation.

6. Installation selon la revendication 5, dans laquelle le creuset de fusion (45) est un creuset froid basculant.

7. Installation selon la revendication 1, dans laquelle le système de fusion (42) est adapté à faire fondre du matériau semiconducteur directement dans le creuset de cristallisation (32).

8. Installation selon la revendication 1, dans laquelle le système de déplacement (20) comprend un bras articulé dont l'extrémité libre est adaptée à se fixer temporairement au creuset de cristallisation (32, 34).

9. Installation selon la revendication 1, comprenant un écran de protection (48) s'interposant entre le système de fusion (42) et le système de purification (46) et adapté à délimiter avec une paroi (47) de la première enceinte (12) un volume de confinement (50) contenant le système de purification, l'écran de protection comportant un orifice (49) en vis-à-vis duquel est destinée à être placée la surface libre du matériau semiconducteur fondu par le système de fusion lors du fonctionnement du système de purification.

10. Procédé de fabrication de blocs d'un matériau semiconducteur comprenant les étapes suivantes :
remplir un creuset de fusion (45) du matériau semiconducteur solide dans une première enceinte (14) contenant une atmosphère d'au moins un gaz neutre ;
faire fondre le matériau semiconducteur solide ;
éliminer des impuretés du matériau semiconducteur fondu ;
déplacer automatiquement le creuset de fusion, ou un creuset de cristallisation (32) dans lequel du matériau semi-conducteur fondu et purifié a été versé, depuis la première enceinte dans une seconde enceinte (14), contenant une atmosphère dudit au moins un gaz neutre et reliée à la première enceinte, avant le début de la solidification du matériau semiconducteur fondu et purifié ;
isoler hermétiquement la seconde enceinte de la pre-, mière enceinte ; et
refroidir le matériau semiconducteur dans la seconde enceinte pour solidifier le matériau semiconducteur fondu et purifié.

## Claims

1. An installation (10) for manufacturing blocks of a semiconductor material, comprising:
at least one first enclosure (12, 14) containing an atmosphere of at least one neutral gas and comprising a melting system (42) capable of melting the semiconductor material, a purification system (46) capable of eliminating impurities from the molten semiconductor material, and a system (20) for displacing a crystallization crucible (32, 34) containing molten semiconductor material purified by the purification system; and
at least one second enclosure (14) containing an atmosphere of said at least one neutral gas and connected to the first enclosure by an opening (16), a mobile gate (18) being capable of tightly closing said opening, the displacement system being capable of displacing the crystallization crucible into the second enclosure before the molten and purified semiconductor material starts solidifying, the second enclosure containing a cooling system (60) capable of promoting the solidification of the molten and purified semiconductor material.

2. The installation of claim 1, in which the cooling system (60) is capable of promoting the segregation of impurities on solidification of the molten and purified semiconductor material in the second enclosure (14).

3. The installation of claim 1, in which the cooling system (60) is capable of promoting the solidification of the molten and purified semiconductor material with no segregation of impurities in the second enclosure (14).

4. The installation of claim 1, in which the first enclosure is divided into a main enclosure (12) and a secondary enclosure (14) communicating with the main enclosure through an opening (16), a mobile gate (18) being capable of tightly closing said opening, the secondary enclosure containing the melting system (40) and the purification system (46), the main enclosure at least partly containing the displacement system (20) and the second enclosure (14) being connected to the main enclosure.

5. The installation of claim 4, in which the melting system (42) comprises a melting crucible (45), separate from the crystallization crucible (32, 34), the installation comprising means for pouring molten and purified semiconductor material from the melting crucible into the crystallization crucible.

6. The installation of claim 5, in which the melting crucible (45) is a cold tilting crucible.

7. The installation of claim 1, in which the melting system (42) is capable of melting semiconductor material directly in the crystallization crucible (32).

8. The installation of claim 1, in which the displacement system (20) comprises an articulated arm having its free end capable of temporarily attaching to the crystallization crucible (32, 34).

9. The installation of claim 1, comprising a protection screen (48) interposing between the melting system (42) and the purification system (46) and capable of delimiting with a wall (47) of the first enclosure (12) a confinement volume (50) containing the purification system, the protection screen comprising an aperture (49) opposite of which is intended to be placed the free surface of the semiconductor material melted by the melting system on operation of the purification system.

10. A method for manufacturing blocks of a semiconductor material, comprising the steps of:
filling a melting crucible (45) with the solid semiconductor material in a first enclosure (14) containing an atmosphere of at least one neutral gas;
melting the solid semiconductor material;
eliminating impurities from the melted semiconductor material;
automatically displacing the melting crucible, or a crystallization crucible (32) in which melted and purified semiconductor material has been poured, from the first enclosure into a second enclosure (14), containing an atmosphere of said at least one neutral gas and connected to the first enclosure, before the beginning of the solidification of the molten and purified semiconductor material;
tightly isolating the second enclosure from the first enclosure; and
cooling down the semiconductor material in the second enclosure to solidify the molten and purified semiconductor material.

## Patentansprüche

1. Eine Installation (10) zum Herstellen von Blöcken von einem Halbleitermaterial, die Folgendes aufweist:
wenigstens eine erste Umschließung (12, 14) die eine Atmosphäre von wenigstens einem neutralen Gas enthält und Folgendes aufweist: ein Schmelzsystem (42), das geeignet ist zum Schmelzen des Halbleitermaterials, ein Reinigungssystem (46) das geeignet ist zum Eliminieren von Verunreinigungen von dem geschmolzenen Halbleitermaterial und ein System (20) zum Verlagern eines Kristallisationstiegels (32, 34), der das durch das Reinigungssystem gereinigte geschmolzene Halbleitermaterial enthält; und
wenigstens eine zweite Umschließung (14), die eine Atmosphäre von wenigstens einem neutralen Gas enthält und mit der ersten Umschließung durch eine Öffnung (16) verbunden ist, ein Mobilgatter (18) das geeignet ist zum festen Schließen der Öffnung, wobei das Verlagerungssystem geeignet ist, den Kristallisationstiegel in die zweite Umschließung zu verlagern, bevor das geschmolzene und gereinigte Halbleitermaterial beginnt fest zu werden, wobei die zweite Umschließung ein Kühlsystem (60) enthält, das geeignet ist die Verfestigung des geschmolzenen und gereinigten Halbleitermaterials zu fördern.

2. Installation nach Anspruch 1, in der das Kühlsystem (60) geeignet ist die Segregation von Verunreinigung beim Verfestigen des geschmolzenen und gereinigten Halbleitermaterials in der zweiten Umschließung (14) zu fördern.

3. Installation nach Anspruch 1, in der das Kühlsystem (60) geeignet ist die Verfestigung des geschmolzenen und gereinigten Halbleitermaterials ohne Segregation von Verunreinigungen in der zweiten Umschließung (14) zu fördern.

4. Installation nach Anspruch 1, in der die erste Umschließung in eine Hauptumschließung (12) und eine sekundäre Umschließung (14) geteilt ist, wobei die sekundäre Umschließung (14) mit der Hauptumschließung durch eine Öffnung (16) kommuniziert, wobei ein Mobilgatter (18) geeignet ist die Öffnung fest zu schließen, die sekundäre Umschließung das Schmelzsystem (40) und das Reinigungssystem (46) enthält, die Hauptumschließung wenigstens teilweise das Verlagerungssystem (20) enthält und die zweite Umschließung (14) mit der Hauptumschließung verbunden ist.

5. Installation nach Anspruch 4, in der das Schmelzsystem (42) einen Schmelztiegel (45) aufweist, der separat von dem Kristallisationstiegel (32, 34) ist, die Installation Mittel aufweist zum Gießen von geschmolzenem und gereinigtem Halbleitermaterial von dem Schmelztiegel in dem Kristallisationstiegel.

6. Installation nach Anspruch 5, in der der Schmelztiegel (45) ein kalt schwenkbarer Tiegel ist.

7. Installation nach Anspruch 1, in der das Schmelzsystem (42) geeignet ist zum Schmelzen von Halbleitermaterial direkt in dem Kristallisationstiegel (32).

8. Installation nach Anspruch 1, in der das Verlagerungssystem (20) einen gegliederten Arm bzw. Gelenkarm aufweist, dessen freies Ende geeignet ist temporär an dem Kristallisationstiegel (32, 34) befestigt zu werden.

9. Installation nach Anspruch 1, die einen Schutzschirm (48) aufweist, der zwischen dem Schmelzsystem (42) und dem Reinigungssystem (46) angeordnet ist und geeignet ist zum Abgrenzen mit einer Wand (47) der ersten Umschließung (12) ein eingesperrtes Volumen (50), das das Reinigungssystem enthält, wobei der Schutzschirm einen Öffnung (49) aufweist, gegenüber der beabsichtigt ist, die freie Oberfläche des Halbleitermaterials zu platzieren, das durch das Schmelzsystem beim Betrieb des Reinigungssystem geschmolzen ist.

10. Ein Verfahren zum Herstellen von Blöcken von einem Halbleitermaterial, wobei das Verfahren die folgenden Schritte aufweist:
Füllen eines Schmelztiegels (45) mit dem festen Halbleitermaterial in einer ersten Umschließung (14), die eine Atmosphäre von wenigstens einem neutralen Gas enthält;
Schmelzen des festen Halbleitermaterials;
Eliminieren von Verunreinigungen von dem geschmolzenen Halbleitermaterial;
automatisches Verlagern des Schmelztiegels oder eines Kristallisationstiegels (32) in dem geschmolzenes und gereinigtes Halbleitermaterial eingegossen worden ist, und zwar von der ersten Umschließung in eine zweite Umschließung (14), die eine Atmosphäre von dem wenigstens einen neutralen Gas enthält und mit der ersten Umschließung verbunden ist, bevor die Verfestigung des geschmolzenen und gereinigten Halbleitermaterials beginnt;
festes Isolieren der zweiten Umschließung von der ersten Umschließung; und
Abkühlen des Halbleitermaterials in der zweiten Umschließung zum Verfestigen des geschmolzenen und gereinigten Halbleitermaterials.
